# EUROPÄISCHE PATENTSCHRIFT

(11) **EP 2 798 740 B1**
(45) Veröffentlichungstag und Bekanntmachung des Hinweises auf die Patenterteilung: **08.07.2015**
(21) Anmeldenummer: 13798981.0
(22) Anmeldetag: 22.11.2013
(51) Int. Cl.: H03K 17/955, H03K 17/96

(54) **KAPAZITIVE SENSOREINRICHTUNG MIT ZUGEHÖRIGER AUSWERTESCHALTUNG**
CAPACITIVE SENSOR DEVICE WITH ASSOCIATED EVALUATION CIRCUIT
SYSTÈME DE CAPTEUR CAPACITIF AVEC CIRCUIT D'ÉVALUATION ASSOCIÉ

(30) Priorität: 18.12.2012 DE 102012112479
(43) Veröffentlichungstag der Anmeldung: 05.11.2014
(73) Patentinhaber: Huf Hülsbeck & Fürst GmbH & Co. KG, 42551 Velbert (DE)
(72) Erfinder: SIEG, Berthold, 46240 Bottrop (DE)
(74) Vertreter: Zenz Patentanwälte Partnerschaft mbB
(86) Internationale Anmeldenummer: PCT/EP2013/074448
(87) Internationale Veröffentlichungsnummer: WO 2014/095223

(56) Entgegenhaltungen:
- WO-A2-2010/045662
- US-B1- 8 154 310

## Beschreibung

Die Erfindung betrifft eine kapazitive Sensoreinrichtung zur Erfassung von Kapazitätsänderungen an einem Annäherungssensor. Bei Annäherung eines Objektes oder Körpers an eine Sensorelektrode erfassen die erfindungsgemäße kapazitive Sensoreinrichtung und die zugehörige Auswerteschaltung eine Veränderung der Kapazität an der Sensorelektrode.

Kapazitive Annäherungsschalter sind im Stand der Technik im Anwendungsbereich für Fahrzeuge bekannt. Beispielsweise offenbart die EP 1505734 einen kapazitiven Näherungsschalter und ein zugehöriges Auswerteverfahren. Derartige kapazitive Näherungsschalter weisen Sensorelektroden auf und sollen dann ansprechen, wenn zwischen der Sensorelektrode und einer Bezugselektrode eine bestimmte Kapazität oder Kapazitätsänderung erfasst wird. Häufig werden dafür mehrere Elektroden in dem Bereich eines Fahrzeuges angeordnet, der zur Bedienungserfassung ausgelegt ist.

Zwischen der Sensorelektrode, die auf ein vorgegebenes Potential gebracht wird und einer Referenzelektrode, z. B. der Fahrzeugmasse oder der Masse des unter dem Fahrzeug befindlichen Bodens bildet sich eine Kapazität aus. Diese Kapazität ist veränderbar, wenn sich in dem sensitiven Bereich der Sensoranordnung ein Körper bewegt, beispielsweise die Hand eines Benutzers oder der Fuß eines Benutzers. Die Erfassung der Kapazität selbst ist in verschiedener Weise möglich. Beispielsweise kann als Messwert für die Kapazität eine Anzahl getakteter Entladevorgänge oder eine Entladezeitdauer verwendet werden. Derartige Auswerteverfahren sind im Stand der Technik hinlänglich bekannt. Beispielsweise ist auch aus der DE 19617038A1 eine kapazitive Erfassung einer Annäherung an einen Fahrzeugtürgriff bekannt.

Bei den bekannten Sensoranordnungen ist es problematisch, dass äußere Einflüsse dazu führen, dass der Kapazitätswert der Sensorelektrode auch ohne Annäherung eines Benutzers verändert wird. Die Kapazität einer Sensorelektrode hängt stark von der Umgebung, beispielsweis der Luftfeuchtigkeit, einer Belegung mit Regen, Schnee, Eis oder Schmutz im Bereich der Sensorelektrode ab. In diesem Zusammenhang ist beispielsweise aus der DE 19620059A1 ein kapazitiver Näherungsschalter bekannt, der nur dann schaltet, wenn sich die Kapazität zwischen Ansprechelektrode und der Bezugselektrode mit einer Geschwindigkeit ändert, die größer als ein unterer Grenzwert ist.

Die WO 2010/045662 offenbart eine kapazitive Sensoreinrichtung mit einer Sensorelektrode welche zur Auswertung der Kapazität mehrfach umgeladen wird und mit einer Kompensationskapazität gekoppelt ist.

Die US 8,154,310 B1 beschreibt einen kapazitiven Sensor mit einer Kapazitätskompensation, wobei ein Stromspiegel zur Auswertung der Kapazität über Umladeströme verwendet ist.

Diese Konzepte ändern jedoch nichts daran, dass die Auswerteschaltung üblicherweise auf einen Arbeitspunkt ausgelegt ist, der einer erwarteten auszuwertenden Kapazität oder Änderung der Kapazität entspricht. Wird die Kapazität durch äußere Einflüsse erheblich verändert, sinkt üblicherweise auch die Genauigkeit der Auswertung, da die Auslegung der Schaltung nicht mehr mit dem Grundwert der Kapazität korrespondiert.

Aufgabe der Erfindung ist es daher, eine verbesserte Sensoranordnung und Auswerteschaltung zur Verfügung zu stellen, die eine Kapazitätsveränderung auch bei veränderbaren Umgebungsbedingungen in verbesserter Weise ermöglicht.

Diese Aufgabe wird erfindungsgemäß gelöst durch eine Einrichtung mit den Merkmalen der unabhängigen Patentansprüche 1 und 8.

Die erfindungsgemäße Lösung eignet sich zum Einsatz an beliebigen kapazitiven Sensorsystemen an Fahrzeugen, z.B. an Türgriffen oder Gestikerkennungen im Heckbereich (z.B. Kick-Sensor).

Die grundlegende Funktionsweise der Sensoranordnung und der zugehörigen Auswerteschaltung besteht zunächst darin, die Sensorelektrode wiederholt mit einem Potential bzw. einer Spannung zu koppeln, um eine der Kapazität entsprechende Aufladung der Sensorelektrode zu veranlassen. Durch eine Schalteinrichtung wird dann die Kopplung der Sensorelektrode mit der Sensorspannung getrennt und die aufgeladene Sensorelektrode wird mit der Auswerteschaltung gekoppelt. Die Auswerteschaltung ist in Grundzügen einem Stromspiegel oder auch einer einfachen Stromquellenschaltung nachgebildet. Wesentlich ist, dass die Entladung der Sensorelektrode, also des zu prüfenden Kondensators über einen Stromzweig realisiert wird, während in einem parallelen, zweiten Stromzweig ein davon abhängiger Ladungsfluss initiiert wird. In dem zweiten Stromzweig bildet sich so über mehrere Schaltzyklen eine messbare Spannung, welche ein Maß für die zu vermessende Kapazität der Sensorelektrode ist.

Die Sensorelektrode ist also mit einer ersten Schalteinrichtung gekoppelt, die unter Steuereinwirkung eine wiederholte und abwechselnde Kopplung der Sensorelektrode einerseits mit einer Sensorbetriebsspannung oder, bei Umschaltung, mit der Auswerteschaltung bewirkt. Diese Umschaltung kann mit hoher Frequenz erfolgen, so dass mehrere Zyklen der Umschaltung zu einer auswertbaren Ladungsverschiebung in der Auswerteschaltung führen. Wie bereits gesagt, ist die Auswerteschaltung zumindest in den wesentlichen Gestaltungsmerkmalen aufgebaut nach Art eines Stromspiegels oder einer Stromquellenschaltung. Die Auswerteschaltung weist entsprechend einen Eingangs-Stromzweig, nämlich den ersten Stromzweig und einen vom ersten Stromzweig abhängigen zweiten Stromzweig auf. Jeder der Stromzweige enthält jeweils mindestens einen Transistor, wobei die Basen der Transistoren leitend gekoppelt sind. Der erste Stromzweig ist über die genannte Schalteinrichtung mit der Sensorelektrode koppelbar. Wird also die erste Schalteinrichtung betätigt, so wird die Sensorelektrode, die zuvor mit der Sensorbetriebsspannung gekoppelt war und entsprechend ihrer Kapazität aufgeladen ist, über den ersten Stromzweig entladen. Diese Entladung findet statt, da die erste Sensorelektrode über die Kopplung mit der Auswerteschaltung sowohl mit der Basis des ersten Transistors im ersten Stromzweig gekoppelt wird, als auch durch die Belegung der Basis und damit Verbundene Durchschaltung des Transistors eine Ableitung der Ladung von der Sensorelektrode über Kollektor und Emitter des ersten Transistors ermöglicht wird. In diesem ersten Stromzweig ist außerdem ein erster Hilfswiderstand R1 angeordnet.

Der zweite Stromzweig ist über die Basis des zweiten Transistors ebenfalls mit der Sensorelektrode koppelbar. Eine Kopplung der geladenen Sensorelektrode erfolgt daher sowohl mit der Basis des ersten Transistors als auch des zweiten Transistors und entsprechend erfolgt eine Schaltung beider Transistoren. Im zweiten Stromzweig, also in Verbindung mit Emitter und Kollektor des zweiten Transistors, ist eine Bezugspotenzial (Bezugsspannungsquelle) angekoppelt. Das Bezugspotenzial kann dasselbe Potential haben wie das der Sensorbetriebsspannung entsprechende Potenzial, es kann jedoch auch auf einem anderen Potenzial (einer andere Spannung) liegen. Außerdem ist im zweiten Stromzweig ein zweiter Hilfswiderstand angeordnet.

Die erfindungsgemäße Auswerteschaltung weist also einen Schaltungsaufbau mit Grundzügen einer Stromspiegelschaltung auf, wobei der Entladestrom einer auszuwertenden Kapazität als Eingangsstrom in den Stromspiegel verwendet wird. In dem zweiten Stromzweig des Ausgangsstroms ist jedoch in Abweichung vom klassischen Aufbau eines Stromspiegels weiterhin eine Hilfskapazität oder Haltekapazität eingekoppelt. Diese Kapazität ermöglich die Akkumulation eines Messwertes über mehrere Schaltzyklen an der Sensorelektrode, welcher im zweiten Stromzweig abgenommen werden kann und als Maß für die Kapazitätsänderung an der Sensorelektrode dient. Unter Akkumulation ist dabei zu verstehen, dass die Haltekapazität immer dann, wenn ein Stromfluss durch den Stromspiegel erfolgt eine Ladungsänderung erfährt. Diese Ladungsänderung wird gehalten, wenn der Stromfluss abbricht. Bei dem nächsten Zyklus wird erneut ein Stromfluss verursacht und weitere Ladung verschoben. Bei Beobachtung der Spannung an der Haltekapazität über mehrere Zyklen ist entsprechend ein treppenförmiger Spannungsverlauf zu erkennen, welche die akkumulierte Ladung verursacht. Sind genügend viele Zyklen absolviert trägt die Haltekapazität eine Ladung (und zeigt eine Spannung), welche ein Maß für die Kapazität der Sensorelektrode ist. Die Hilfskapazität wird nach Auswertung für eine erneute Folge von Zyklen wieder entladen, z.B. indem zeitweise eine geschaltete Kopplung mit Masse erfolgt.

Gemäß der Erfindung ist in den ersten Stromzweig eine zusätzliche, mit Schaltern versehene Kapazität als Kompensationskapazität einkoppelbar. Einkoppelbar heißt in diesem Zusammenhang, dass die Kapazität grundsätzlich parallel zu der auszuwertenden Sensorelektrodenkapazität in den ersten Stromzweig zuschaltbar ist, jedoch mit einer Schaltanordnung versehen ist, die den zweiten Anschluss der Kapazität entweder mit der Sensorbetriebsspannung koppelt, oder eine Kopplung mit Masse herstellt oder die Kapazität an diesem Anschluss potentialfrei (floating) lässt.

Der wesentliche Vorteil der Einkopplung dieser Kapazität besteht darin, dass verschiedene Messbereiche geschaltet werden können. Die Schalter der Kompensationskapazität und die Schalter zur Kopplung der Sensorelektrode mit der Auswerteschaltung sind üblicherweise synchronisiert. Die Kompensationskapazität wird in der messfreien Zeit auf die Sensorbetriebsspannung gelegt. Gleichzeitig mit der Kopplung der Sensorelektrode und deren Entladung in die Auswerteschaltung erfolgt, je nach Bereichswahl der Messung eine Kopplung der Kompensationskapazität mit dem Massepotential oder der potentialfreien Ansteuerung. In Abhängigkeit von der Schaltung ist die für die Auswerteschaltung sichtbare Kapazität und der für die Auswerteschaltung damit sichtbare Stromfluss unterschiedlich. Die Einkopplung der Kompensationskapazität erfolgt, wenn ansonsten durch Umwelteinflüsse oder Verschmutzung der Sensorelektrode eine Entfernung vom optimalen Arbeitspunkt der Auswerteschaltung vorliegen würde.

Die Wirkung der Erfindung wird unten, unter Bezug auf ein Ausführungsbeispiel konkret erläutert. Bereits an dieser Stelle werden aber die wesentlichen Schritte des erfindungsgemäßen Konzepts bei der Auswertung in allgemeiner Weise beschrieben.

Zu Beginn eines Messzyklus wird die erste Schalteinrichtung zu Kopplung der kapazitiven Sensorelektrode mit einer Betriebsspannung geschaltet. Die Sensorelektrode ist also entkoppelt von der Auswerteschaltung sondern wird entsprechend ihrer Kapazität und der Betriebsspannung geladen.

Die Auswerteschaltung ist gleichzeitig so geschaltet, dass die Hilfskapazität (oder Haltekapazität) im zweiten Stromzweig einseitig mit einer Spannung beaufschlagt ist, der Stromfluss durch den zweiten Stromzweig aber gesperrt ist, da im ersten Stromzweig kein Strom fließt und erster und zweiter Stromzweig als Stromspiegel wirken.

In einem zweiten Schritt erfolgt die Schaltung der ersten Schalteinrichtung, wodurch die Sensorelektrode von der Betriebsspannung entkoppelt und mit der Auswerteschaltung, und zwar dem ersten Stromzweig des Stromspiegels gekoppelt wird.

Wird zunächst die Wirkung der Kompensationskapazität unberücksichtigt gelassen, würde aufgrund der im System vorliegenden Spannungen nun ein Stromfluss von der geladenen Sensorelektrode durch den ersten Stromzweig des ersten Stromspiegels erfolgen, der einen entsprechenden Stromfluss im zweiten Stromzweig bewirkt. Im zweiten Stromzweig befindet sich die Haltekapazität, die durch den Stromfluss umgeladen wird. Durch diese Umladung der Haltekapazität wird eine abgreifbare Spannung an dieser Haltekapazität hervorgerufen.

Dieser Vorgang wird einige Male wiederholt, also die Sensorelektrode von der Auswerteschaltung entkoppelt, mit der Betriebsspannung gekoppelt, aufgeladen und erneut mit der Auswerteschaltung gekoppelt, wobei die Haltekapazität über diese Zyklen immer mehr Ladung akkumuliert und Spannung aufbaut. Nach einigen Zyklen, z.B. 5-15 Zyklen, wird die Spannung der Haltekapazität ausgewertet und als Maß für die Kapazität der Sensorelektrode gewandelt.

Gemäß der Erfindung ist jedoch eine Kompensationskapazität im ersten Stromzweig vorgesehen. Diese Kompensationskapazität ist z.B. parallel zu dem ersten Stromzweig gekoppelt. Dadurch entsteht in der Phase des Stromflusses durch den Stromspiegel eine abweichende Betrachtung. Je nachdem, wie die Kompensationskapazität geschaltet ist, fließt ein Anteil des Entladestromes von der Sensorelektrode nicht durch den ersten Stromzweig sondern in Richtung der Kompensationskapazität. Dieser Strom geht dem Stromspiegel verloren, er wird entsprechend auch im zweiten Stromzweig nicht gesehen und führt mit seinem Anteil nicht zu einer Umladung des Haltekondensators.

Ein Teil der Ladung der Sensorelektrode wird also kompensiert, indem er der Auswertung im Stromspiegel entzogen wird, nämlich durch Abzweigung in Richtung der Kompensationskapazität. Da die Kopplung des zweiten Anschlusses der Kompensationskapazität mit einer wählbaren Spannung, mit Masse oder Floating-Potenzial die Umladung der Kompensationskapazität beeinflusst ist ersichtlich. Entsprechend kann das Maß der Kompensation durch diese Vorauswahl und Kopplung über die zweite Schalteirichtung angepasst werden. Diese Anpassung erfolgt in Abhängigkeit von den erfassten Spannungswerten an der Haltekapazität, um diese auflaufenden Spannungswerte im gewünschten Rahmen zu halten.

In einer bevorzugten Weiterbildung der Erfindung sind mehrere Kompensationskapazitäten, z. B. zwei Kompensationskapazitäten parallel zuschaltbar, wobei jede getrennt entweder mit Masse koppelbar ist oder mit schwebendem Potential schaltbar ist. Dadurch ergibt sich eine Variation der sichtbaren Stromflüsse für die Auswerteschaltung in verschiedenen Messbereichen, je nach Kombination der Schaltungen der Kompensationskapazitäten.

Im Ast des Ausgangsstromes der Auswerteschaltung wird der dort sichtbare Strom für die Akkumulation der Messwerte wirksam. Es ist in diesem Zusammenhang nicht relevant, ob dieser Strom aus der Entladung der Sensorelektrodenkapazität kommt oder aus den Kompensationskapazitäten. Daher kann der zweite Strang der Auswerteschaltung auf einen Arbeitsbereich eingestellt werden und wenn die ausgewerteten Daten den Arbeitsbereich verlassen, können durch Zuschaltung der Kompensationskapazitäten die Messdaten in den Arbeitsbereich zurückgeführt werden.

Es ist ersichtlich, dass die Kompensationskapazitäten gleiche Kapazitätswerte aufweisen können, dies ist jedoch keinesfalls erforderlich.

Gemäß der Erfindung ist die Kompensationsspannung an der Kompensationskapazität variabel. Die Kompensationsspannung ist über die Kompensationskapazität mit dem ersten Stromzweig gekoppelt. In Abhängigkeit von der Spannung, die an dem Stromzweig-abgewandten Anschluss der Kompensationskapazität anliegt, kann Ladung auf die Kompensationskapazität verschoben werden, wenn die Sensorelektrode mit dieser zur Auswertung gekoppelt wird. Wird an der Kompensationskapazität ein "Spannungs-Gegendruck" aufgebaut, so wird weniger Ladung auf die Kapazität fließen und entsprechend größerer Stromfluss durch den Stromspiegel erfolgen. Wird andererseits ein "Spannungs-Sog" erzeugt, so wird mehr Ladung aus der Auswerteschaltung in Richtung Kompensationskapazität abgeführt und weniger Strom fließt durch den Stromspiegel.

Die Erfindung wird nun anhand des beiliegenden Ausführungsbeispiels näher erläutert.
Figur 1 zeigt eine schematische Ansicht der am Fahrzeug vorliegenden Kapazitäten;
Figur 2 zeigt ein beispielhaftes reduziertes Blockschaltbild;
Figur 3 zeigt ein Ausführungsbeispiel der Erfindung als reduziertes Blockschaltbild;

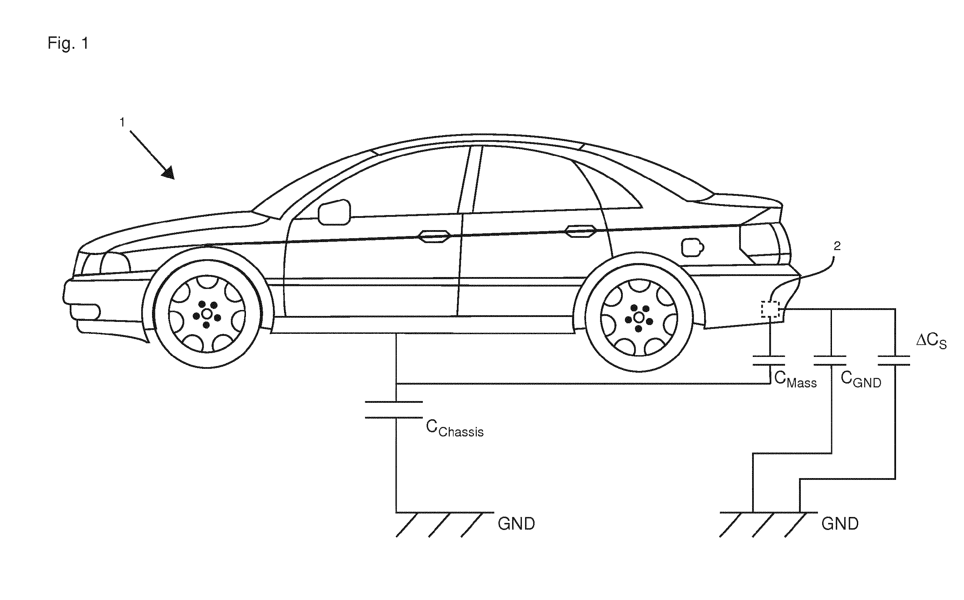

In Figur 1 ist ein Fahrzeug 1 dargestellt, welches im Heckbereich einen kapazitiven Sensor 2 aufweist. Der Sensor 2 ist als Sensorelektrode ausgebildet, die im hinteren Stoßfänger des Fahrzeugs angeordnet ist. Bei Betätigungswunsch an einer Kofferraumabdeckung kann ein Benutzer eine Bewegungsgeste ausführen, insbesondere den Fuß unter das Fahrzeugheck bewegen, damit die Kapazität der Sensorelektrode verändern und so die Öffnung des Kofferraums auslösen.

Die Elektrode erstreckt sich in der Fahrzeugbreite über den gesamten Stoßfänger oder einen bestimmten Teilabschnitt, in welchem der Benutzer die Geste auszuführen hat.

In der Abbildung sind schematisch die zu berücksichtigenden Kapazitäten des Fahrzeugs gezeigt. Gegenüber dem tatsächlichen Erdpotential weist das Chassis des Fahrzeugs eine Kapazität auf, die regelmäßig um Größenordnungen größer ist als die übrigen Kapazitäten. Die Kapazität C_{Chassis} beträgt üblicherweise mehrere 100 pF oder auch noch höhere Kapazitäten. Für die folgende Betrachtung ist entsprechend dieser Kapazität des Fahrzeugchassis gegenüber dem Erdpotential regelmäßig vernachlässigbar, da das Fahrzeugchassis selbst gegenüber der Sensorelektrode eine Fahrzeugmasse bildet, welche in der schematischen Darstellung als C_{Mass} bezeichnet ist.

Des Weiteren weist die Sensorelektrode 2 eine Kapazität gegenüber dem Erdpotential auf, diese beträgt einige pF z. B. etwa 5 pF. Entsprechend gilt in dieser schematischen Betrachtung C_{GND} gleich 5 pF.

Außerdem wird eine veränderliche Kapazität ΔC_{S} parallel zu C_{GND} wirken. Diese veränderliche Kapazität ist abhängig von Umgebungsbedingungen oder auch der Bewegung eines Körpers in dem Umgebungsbereich der Sensorelektrode 2. Für diesen Effekt gibt es grundsätzlich verschiedene Betrachtungsweisen, einerseits wird das Dielektrikum um die Sensorelektrode 2 herum verändert, andererseits kann eine Einkopplung einer weiteren Kapazität (Körper des Bedieners) parallel zu C_{GND} zu einer Erklärung herangezogen werden. Unabhängig von der Betrachtungsweise ist jedoch die Kapazität ΔC_{S} diejenige Kapazität, welche für die Betätigungserkennung detektiert werden soll. Hierbei ist die Kapazität ΔC_{S}, also die Veränderung der Kapazität durch äußere Einflüsse oder Betätigung deutlich geringer als die Kapazität C_{GND}. Üblicherweise beträgt die Kapazität ΔC_{S} weniger als ein pF, beispielsweise weniger als 0,5 pF.

Die Kapazität C_{GND} wird durch Umwelteinflüsse, beispielsweise trocknendes Salzwasser, Schmierbeläge oder auch Lackaufträge auf dem Stoßfänger verändert. Wenn die Kapazität C_{GND} erhöht wird, ist die tatsächliche Detektionskapazität ΔC_{S} schwerer zu erfassen. Die Feldlinien des elektrischen Feldes, welches durch die Sensorelektrode 2 hervorgerufen wird, werden durch derartige Störungen, insbesondere leitende Schichten stark beeinflusst und erstrecken sich nicht mehr ausreichend in den Detektionsbereich.

Es ist daher wichtig, kleine Kapazitätsänderungen zu erkennen, auch wenn die jederzeit vorliegende Basiskapazität veränderlich ist.

Die Erfindung setzt hierbei an, indem in Abhängigkeit von den erfassten Messwerten eine Verschiebung des Arbeitspunktes der Schaltung möglich ist.

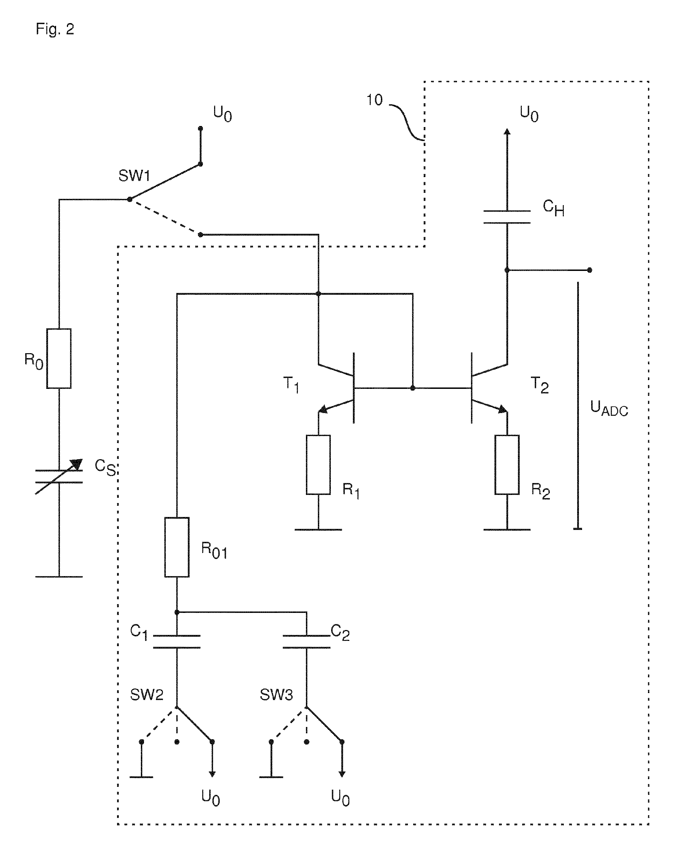

Figur 2 zeigt eine beispielhafte schematische Schaltung. Es ist erkennbar, dass die Schaltung in Abschnitten einer einfachen Stromquellenschaltung oder auch einem Stromspiegel entlehnt ist.

Die zu erfassende, veränderliche Kapazität C_{S} der Sensorelektrode ist in dem Schaubild als variable Kapazität dargestellt. Diese Kapazität ist beispielhaft mit einem Dämpfungswiderstand R0 gekoppelt sowie mit einer ersten Schalteinrichtung SW1. Die Schalteinrichtung SW1 ist elektronisch ansteuerbar und kann die Sensorelektrode, also die Kapazität C_{S}, mit einer Betriebsspannung U0 koppeln. In einer anderen Schaltstellung wird mittels der Schalteinrichtung SW1 diese Kopplung gelöst und die Sensorelektrode wird zur Auswertung mit der Auswerteschaltung 10 gekoppelt.

Wie im Bild gezeigt, stellt bei Kopplung der Sensorelektrode mit Kapazität C_{S} mit der Auswerteschaltung 10 die Entladung der Sensorelektrode die Seite des Eingangsstromes des Stromspiegels dar. Dafür sind bei dem Transistor T1 Kollektoranschluss und Basisanschluss verbunden und mit der Sensorelektrode koppelbar. Fließt ein Eingangsstrom durch den Transistor T1, so stellt sich eine Basis-Emitter-Spannung ein, die mit dem Eingangsstrom verknüpft ist.

Die Basisanschlüsse der beiden Transistoren T1 und T2 sind verbunden. Im zweiten Stromzweig der Auswerteschaltung, gebildet durch die "Sample and Hold" oder Haltekapazität C_{H}, den Transistor T2 und dem Hilfswiderstand R₂ ist ebenfalls mit der Versorgungsspannung U₀ gekoppelt. Eine Spannung U_{ADC} ist abgreifbar. Diese Spannung dient nach Akkumulation einer Ladung auf der Kapazität C_{H} über mehrere Meßzyklen als Maß für die Kapazität C_{S}.

Dieses Beispiel weist jedoch parallel zu dem ersten Stromzweig des Stromspiegels Kompensationskapazitäten auf. In diesem Beispiel sind dazu zwei weitere Schalteinrichtungen SW2 und SW3 mit zugehörigen Kompensationskapazitäten C₁ und C₂ gekoppelt. Je nach Schalterstellung der Schalter SW2 und SW3 können die Kapazitäten mit ihren in der Darstellung unten liegenden Anschluss entweder auf Massepotential, oder auf schwebendes Potential gelegt werden. In den Phasen, in denen der Schalter SW1 die Sensorelektrode mit Versorgungsspannung U₀ koppelt, können auch die Kondensatoren C1 und C2 mit der Versorgungsspannung U₀ gekoppelt werden.

Zur Auswertung der Kapazität C_{S} wird der Schalter SW1 für eine mehrfache Anzahl von Umschaltungen betätigt, so dass die Kapazität C_{S} immer wieder aufgeladen und über die Auswerteschaltung entladen wird.

Die Schritte sind dabei Folgende:
- Koppeln der Kapazität C_{S} mit der Betriebsspannung U₀ mittels Schalteinrichtung SW1, wodurch C_{S} entsprechend der Kapazität der Sensorelektrode geladen wird;
- Entkoppeln der Kapazität C_{S} von der Betriebsspannung U₀ mittels Schalteinrichtung SW1, wodurch C_{S} die bestehende Ladung behält;
- Koppeln der Kapazität C_{S} mit der Auswerteschaltung 10, wobei ein Ladungsausgleich zwischen C_{S} und den Kapazitäten C₁ und C₂ erfolgt, wobei der Ladungsfluss von den Ladungszuständen von C₁ und C₂ sowie den über SW2 und SW3 angekoppelten Potenzialen abhängt (die Schalter SW1 und SW2 bzw. SW3 werden gleichzeitig geschaltet);
- Der nicht kompensierte Ladungsanteil, also der Ladungsteil von CS, welcher nicht in Richtung C1 und C2 fließt, wird durch ersten, linken Zweig des Stromspiegels geleitet und bewirkt im zweiten, rechten Zweig einen entsprechenden Strom;
- Der im rechten Zweig verursachte Stromfluss führt zu einer Ladungsänderung auf C_{H}, die korreliert ist zu der unkompensierten Ladungsmenge aus C_{S};
- SW1 wird wieder zur Aufladung von CS betätigt und der Vorgang beginnt von neuem, wobei auf C_{H} eine Ladung akkumuliert wird, die in Gestalt der Spannung U_{ADC} abfragbar ist;
- Die Schritte werden acht bis zehnmal wiederholt, dann wird die Spannung U_{ADC} A/D-gewandelt und als repräsentativer Wert für die Ladung auf C_{H}-interpretiert;
- C_{H} wird von der akkumulierten Ladung entladen und es wird ein neuer Meßzyklus gestartet;

Die sich einstellende Spannung U_{ADC} ist abhängig sowohl von der Anzahl der Umschaltungen, als auch der Versorgungsspannung und dem Verhältnis der Kapazitäten C_{S} und C_{H} sowie der Verhältnisse der Widerstände R1 und R2. Die quantitativen Verhältnisse lassen sich durch einfache Schaltungssimulationen und das Fachwissen hinsichtlich von Stromspiegeln auf den jeweiligen Anwendungsfall anpassen.

Wird anhand der ermittelten Werte erkannt, dass sich die erfassten Spannungswerte U_{ADC} nicht im Auslegungsbereich der Schaltung bewegen, also eine veränderliche Kapazität nur unzureichend genau festgestellt werden kann, können die Schalter SW2 und SW3 in verschiedenen Bereichen und Kombinationen verstellt werden, so dass entweder beide Kapazitäten C1 und C2 auf schwebendem Potential gehalten werden, eine der Kapazitäten mit dem Massepotential gekoppelt wird oder auch beide Kapazitäten mit dem Massepotential gekoppelt werden.

Anhand des Schaubildes ist es unmittelbar ersichtlich, dass die Zuschaltung der Kapazitäten C1 und C2 zusätzlich zu der Kapazität C_{S} die Auswerteschaltung beeinflusst, indem die zu erfassende Kapazität wieder in den Auslegungsbereich verschoben wird.

Auf diese Weise sind sensitive Erfassungen auch bei widrigen Umweltbedingungen, insbesondere Belegung der Sensorelektrode z.B. durch Salzkrusten oder Schmutz möglich. Wesentlich ist also, dass der Kompensationsbereich in situ angepasst werden kann, je nachdem welche Messbereichsverschiebung erforderlich ist.

In Weiterbildungen der Erfindung können auch größere Anzahlen von Kompensationskapazitäten eingebracht werden.

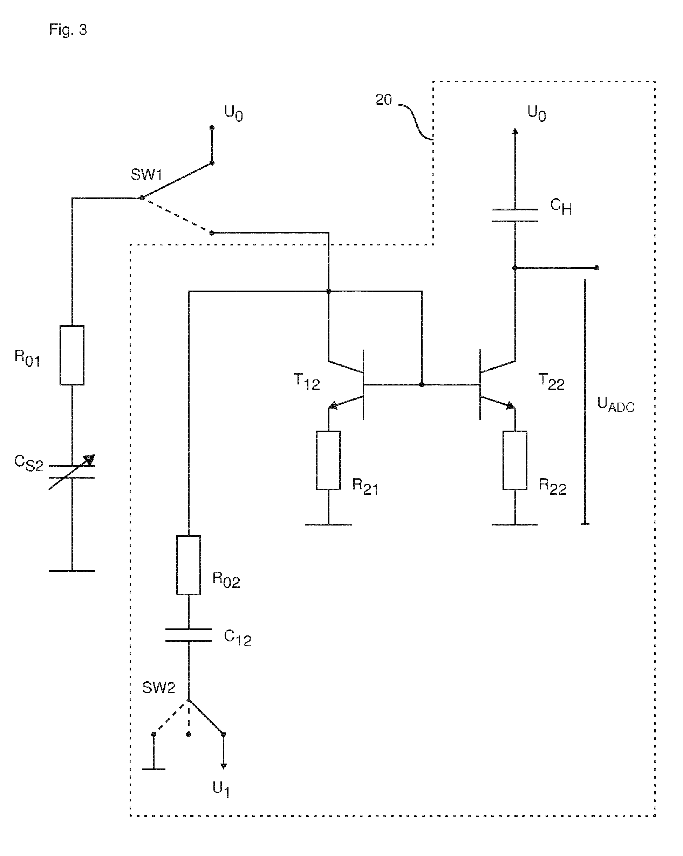

In Figur 3 ist ein Ausführungsbeispiel der Erfindung dargestellt. Hier wird eine Ladungskompensation erreicht, indem ein Kompensations-Kondensator mit fester Kapazität C₁₂ eingesetzt wird. Dieser Kondensator ist jedoch mit einer einstellbaren Spannung U₁, der Kompensationsspannung, koppelbar. Entsprechend wird bei der Erfindung die Ladungskompensation über die variable Kompensationsspannung U₁ und nicht über die Veränderung der Kondensator-Kapazitäten erreicht. Für die Kompensationsspannung gilt dabei vorzugsweise U₁<=U₀. Die Spannung bewirkt einen veränderlichen Spannungssog oder Spannungsdruck an der Kompensationskapazität. Je nach eingestellter Spannung kann daher die gekoppelte Kompensationskapazität unterschiedlich viel Ladung aufnehmen, die damit vor dem Stromspiegel abgezweigt wird und nicht zur Umladung der Haltekapazität führt.

Im Rahmen der Erfindung kann auch eine Kombination der vorgestellten Kompensationsmethoden eingesetzt werden, es können also mehrere Kapazitäten zuschaltbar angeordnet werden, von denen eine oder mehrere mit einstellbaren Spannungsquellen gekoppelt sind. Dadurch ist eine besonders feine Kompensationseinstellung möglich. Die einstellbaren Spannungsquellen werden dabei gemäß bekannter Verfahren angesteuert, um die Ladungsmenge auf den Kompensationskapazitäten anzupassen, so dass die Sensitivität der Messschaltung in den gewünschten Messbereich zurückgeführt wird.

Im Rahmen der Erfindung sind Abweichungen, insbesondere hinsichtlich der Anzahl von sensierten Kapazitäten und auch Kompensations-Kapazitäten möglich. Statt der dargestellten einzelnen sensierten Kapazität (C_{S}) können mehrere Sensorelektroden bzw. Sensorkapazitäten mit zugeordneten Schalteinrichtungen mit derselben Auswerteschaltung gekoppelt sein. Außerdem kann auch der Teil der Schaltung, der als Stromspiegelschaltung ausgebildet ist, im Rahmen der bekannten Gestaltungsalternativen für Stromspiegelschaltungen variiert werden, solange sie unter den Umfang der folgenden Ansprüche fallen.

## Patentansprüche

1. Kapazitive Sensoreinrichtung mit wenigstens einer Sensorelektrode, welche gegenüber einem Bezugspunkt mit einem Bezugspotenzial eine veränderbare Kapazität bildet,
wobei die Sensorelektrode mit einer ersten Schalteinrichtung (SW1) gekoppelt ist, wobei diese erste Schalteinrichtung zur wiederholten Kopplung der Sensorelektrode entweder mit einer Sensorbetriebsspannung (U0) oder einer Auswerteschaltung (10) schaltbar ist, wobei die Auswerteschaltung (10) nach Art einer Stromquellenschaltung wenigstens einen ersten Stromzweig mit wenigstens einem ersten Transistor (T1) und wenigstens einen zweiten Stromzweig mit wenigstens einem zweiten Transistor (T2) aufweist,
wobei der erste Stromzweig an einem Eingangsende mit der Sensorelektrode koppelbar ist und über Kollektor und Emitter des ersten Transistors mit Masse koppelt, wobei in dem ersten Stromzweig ein erster Hilfswiderstand (R1) angeordnet ist,
wobei der zweite Stromzweig an einem Ende mit einer Auswertespannung gekoppelt ist, einen zwischen Auswertespannung und zweitem Transistor gekoppelte Haltekapazität (CH) aufweist und wobei in dem zweiten Stromzweig wenigstens ein zweiter Hilfswiderstand (R2) angeordnet ist,
wobei die Basis des ersten Transistors (T1) mit der Basis des zweiten Transistors (T2) gekoppelt ist und sowohl die Basis des ersten Transistors (T1) als auch die Basis des zweiten Transistors (T2) über die Schalteinrichtung (SW1) mit der Sensorelektrode koppelbar ist,
wobei wenigstens eine Kompensationskapazität (C1) vorgesehen ist, deren erster Anschluss mit dem ersten Stromzweig gekoppelt ist und über die erste Schalteinrichtung (SW1) parallel zu der Sensorelektrode mit dem ersten Stromzweig koppelbar ist,
wobei der zweite Anschluss der Kompensationskapazität C1 mittels einer zweiten Schalteinrichtung (SW2) mit einer Kompensationsspannung (U1) oder Masse oder potenzialfrei koppelbar ist,
wobei die an die wenigstens eine Kompensationskapazität (C₁₂) anlegbare Kompensationsspannung (U₁) durch eine variable Gleichspannungsquelle bereitgestellt ist, so dass in Abhängigkeit von der Kompensationsspannung die Ladungsmenge auf der Kompensationskapazität variabel ist.

2. Kapazitive Sensoreinrichtung nach Anspruch 1, wobei die Sensorbetriebsspannung und die Auswertespannung dieselbe Spannung aufweisen.

3. Kapazitive Sensoreinrichtung nach einem der vorangehenden Ansprüche, wobei wenigstens eine weitere Kompensationskapazität (C2) vorgesehen ist, deren erster Anschluss mit dem ersten Stromzweig gekoppelt ist und über die erste Schalteinrichtung (SW1) parallel zu der Sensorelektrode mit dem ersten Stromzweig koppelbar ist,
wobei der zweite Anschluss der Kompensationskapazität (C2) mittels einer dritten Schalteinrichtung (SW3) koppelbar mit der Sensorbetriebsspannung oder Masse oder potenzialfrei (floating) schaltbar ist.

4. Kapazitive Sensoreinrichtung nach einem der vorangehenden Ansprüche, wobei wenigstens die erste Schalteinrichtung mit einer Steuereinrichtung zur wiederholten Schaltung zur wechselnden Kopplung der Sensorelektrode mit der Sensorbetriebsspannung oder der Auswerteschaltung ausgebildet ist.

5. Kapazitive Sensoreinrichtung nach einem der vorangehenden Ansprüche, wobei eine im zweiten Stromzweig zwischen Kondensator (CH) und Masse abfallende Spannung als Maß für die Kapazität der Sensorelektrode mit einer Erfassungseinrichtung abgreifbar ist, wobei ein AD-Wandler zur Aufbereitung der Spannung mit dem zweiten Stromzweig gekoppelt ist.

6. Kapazitive Sensoreinrichtung nach Anspruch 5, wobei die im zweiten Stromzweig abfallende Spannung mit der Erfassungseinrichtung jeweils nach einer Mehrzahl von Schaltvorgängen der Schalteinrichtung SW1 abgreifbar ist, so dass der vom Ladezustand des Haltekondensators abhängige Spannungswert sich über die Mehrzahl von Schaltvorgängen akkumuliert.

7. Kapazitive Sensoreinrichtung nach einem der vorangehenden Ansprüche, wobei in dem ersten Stromzweig ein erster Hilfswiderstand (R1) angeordnet ist, und
wobei in dem zweiten Stromzweig wenigstens ein zweiter Hilfswiderstand (R2) angeordnet ist.

8. Verfahren zum Erfassen einer Kapazität einer
Sensorelektrode, mit den Schritten:
Aufladen einer Sensorelektrode durch Koppeln der Sensorelektrode mit einer Betriebsspannung (U0),
Entkoppeln der Sensorelektrode von der Betriebsspannung und Koppeln der Sensorelektrode mit einer Kompensationskapazität (C12), um einen Ladungsausgleich zwischen Kompensationskapazität und Sensorelektrode herbeizuführen,
wobei die Kompensationskapazität aus einem oder mehreren Kondensatoren gebildet wird, die über eine Schalteinrichtung wahlweise mit einer Kompensationsspannung, mit Masse oder potentialfrei gegen die Sensorelektrode koppelbar sind,
wobei ein Ableiten der Restladung der Sensorelektrode durch einen ersten Stromweg eines Stromspiegels erfolgt, wobei ein entsprechender Strom in einem zweiten Stromweg des Stromspiegel hervorgerufen wird und wobei ein im zweiten Stromweg eingekoppelter Haltekondensator durch den hervorgerufenen Strom umgeladen wird,
mehrfaches Wiederholen der vorstehenden Schritte und anschließendes Auswerten des Ladezustandes des Haltekondensators als Maß für die Kapazität der Sensorelektrode,
wobei die Kompensationsspannung variabel ist und in
Abhängigkeit von dem ermittelten Ladezustand der Haltekapazität vorgegeben wird.

9. Verfahren nach Anspruch 8, wobei die Kopplung der einzelnen Kapazitäten mit der Sensorelektrode in Abhängigkeit von dem ermittelten Ladezustand der Haltekapazität vorgenommen wird.

## Claims

1. A capacitive sensor device having at least one sensor electrode, which forms a variable capacitance with respect to a reference point with a reference potential,
wherein the sensor electrode is coupled to a first switching device (SW1), said first switching device being switchable for repeated coupling of the sensor electrode either to a sensor operating voltage (U0) or to an evaluation circuit (10),
wherein the evaluation circuit (10), configured in the manner of a power source circuit, has at least one first current path with at least one first transistor (T1), and at least one second current path with at least one second transistor (T2),
wherein the first current path can be coupled to the sensor electrode at an input end and couples to ground via a collector and an emitter of the first transistor, an auxiliary resistor (R1) being arranged in the first current path,
wherein the second current path is coupled to a reference potential at one end and has a storage capacitor (CH) coupled between the reference potential and the second transistor and wherein at least one second auxiliary resistor (R2) is arranged in the second current path,
wherein the base of the first transistor (T1) is coupled to the base of the second transistor (T2) and both the base of the first transistor (T1) and the base of the second transistor (T2) can be coupled to the sensor electrode via the switching device (SW1), wherein at least one compensation capacitor (C1) is provided, the first terminal of which is coupled to the first current path and can be coupled via the first switching device (SW1) in parallel with the sensor electrode to the first current path,
wherein the second terminal of the compensation capacitor C1 can be coupled to a compensation voltage (U₁) or to ground or in a floating manner by means of a second switching device (SW2),
wherein the compensation voltage (U₁) that can be applied to the at least one compensation capacitor (C₁₂) is provided by a variable DC voltage source, so that the charge quantity on the compensation capacitor is variable as a function of the compensation voltage.

2. The capacitive sensor device according to claim 1, wherein the sensor operating voltage and the reference voltage have the same voltage.

3. The capacitive sensor device according to any one of the previous claims, wherein at least one additional compensation capacitor (C2) is provided, the first terminal of which is coupled to the first current path and can be coupled via the first switching device (SW1) in parallel with the sensor electrode to the first current path,
wherein the second terminal of the compensation capacitor (C2) can be connected to the sensor operating voltage or to ground or in a floating manner by means of a third switching device (SW3).

4. The capacitive sensor device according to any one of the previous claims, wherein at least the first switching device is implemented with a control device for repeated switching to the alternating coupling of the sensor electrode to the sensor operating voltage or to the evaluation circuit.

5. The capacitive sensor device according to any one of the previous claims, wherein a decreasing voltage in the second current path between storage capacitor (CH) and ground can be tapped off with a sensing device as a measure of the capacitance of the sensor electrode, wherein an A-D converter is coupled to the second current path to provide the voltage.

6. The capacitive sensor device according to claim 5, wherein the decreasing voltage in the second current path can be tapped off with the sensing device in each case according to a plurality of switching processes of the switching device SW1, so that the voltage value that depends on the charge state of the storage capacitor is accumulated over the plurality of switching processes.

7. The capacitive sensor device according to any one of the previous claims, wherein an auxiliary resistor (R1) is arranged in the first current path, and wherein at least one second auxiliary resistor (R2) is arranged in the second current path.

8. A method for detecting a capacitance of a sensor electrode, having the steps:
charging of a sensor electrode by coupling the sensor electrode to an operating voltage (U0),
decoupling of the sensor electrode from the operating voltage and coupling of the sensor electrode to a compensation capacitor (C12), in order to achieve a charge compensation between compensation capacitor and sensor electrode,
wherein the compensation capacitor is formed from one or more capacitors, that can be coupled via a switching device either to a compensation voltage, to ground or in a floating manner relative to the sensor electrode,
wherein the remaining charge of the sensor electrode is dissipated by means of a first current path of a current mirror, wherein a corresponding current is induced in a second current path of the current mirror and wherein a storage capacitor connected into the second current path is recharged by the induced current,
multiple repetitions of the above steps and subsequent evaluation of the charge state of the storage capacitor as a measure of the capacitance of the sensor electrode,
wherein the compensation voltage is variable and is specified as a function of the determined charge state of the storage capacitor.

9. The method according to claim 8, wherein the coupling of the individual capacitors to the sensor electrode is carried out in accordance with the determined charge state of the storage capacitor.

## Revendications

1. Dispositif de capteur capacitif avec au moins une électrode de capteur, laquelle forme une capacité variable par rapport à un point de référence avec un potentiel de référence,
l'électrode de capteur étant couplée à un premier dispositif de commutation (SW1), ce premier dispositif de commutation pouvant être commuté pour le couplage répété de l'électrode de capteur à une tension de service de capteur (U0) ou un circuit d'évaluation (10),
dans lequel le circuit d'évaluation (10) présente, à la manière d'un circuit formant source de courant, au moins une première branche de courant avec au moins un premier transistor (T1) et au moins une deuxième branche de courant avec au moins un deuxième transistor (T2),
dans lequel la première branche de courant peut être couplée, à une extrémité d'entrée, à l'électrode de capteur et se couplant à la masse via un collecteur et un émetteur du premier transistor, une première résistance auxiliaire (R1) étant disposée dans la première branche de courant,
dans lequel la deuxième branche de courant est couplée, à une extrémité, à une tension d'évaluation, présente une capacité de maintien (CH) couplée entre la tension d'évaluation et un deuxième transistor, et dans lequel au moins une deuxième résistance auxiliaire (R2) est disposée dans la deuxième branche de courant,
dans lequel la base du premier transistor (T1) est couplée à la base du deuxième transistor (T2), et la base du premier transistor (T1) tout comme également la base du deuxième transistor (T2) pouvant être couplées via le dispositif de commutation (SW1) à l'électrode de capteur,
dans lequel au moins une capacité de compensation (C1) est prévue, dont le premier raccord est couplé à la première branche de courant et peut être couplé, via le premier dispositif de commutation (SW1), parallèlement à l'électrode de capteur, à la première branche de courant,
dans lequel le deuxième raccord de la capacité de compensation C1 peut être couplé au moyen d'un deuxième dispositif de commutation (SW2) à une tension de compensation (U₁) ou à la masse ou de manière libre de potentiel,
dans lequel la tension de compensation (U₁) pouvant être appliquée à cette au moins une capacité de compensation (C₁₂) est mise à disposition grâce à une source de tension continue variable, de sorte qu'en fonction de la tension de compensation, la quantité de charge sur la capacité de compensation est variable.

2. Dispositif de capteur capacitif selon la revendication 1, dans lequel la tension de service du capteur et la tension d'évaluation présentent la même tension.

3. Dispositif de capteur capacitif selon l'une des revendications précédentes, dans lequel on prévoit au moins une autre capacité de compensation (C2) dont le premier raccord est couplé à la première branche de courant et peut être couplé via le premier dispositif de commutation (SW1), parallèlement à l'électrode de capteur, à la deuxième branche de courant,
dans lequel le deuxième raccord de la capacité de compensation (C2) peut être commuté au moyen d'un troisième dispositif de commutation (SW3) de manière à pouvoir être couplé à la tension de service de capteur ou à la masse ou de manière libre de potentiel (floating).

4. Dispositif de capteur capacitif selon l'une des revendications précédentes, dans lequel au moins le premier dispositif de commutation est réalisé avec un dispositif de commande pour la commutation répétée pour le couplage alterné de l'électrode de capteur à la tension de service de capteur ou au circuit d'évaluation.

5. Dispositif de capteur capacitif selon l'une des revendications précédentes, dans lequel une tension en chute dans la deuxième branche de courant, entre le condensateur (CH) et la masse, peut être saisie en tant que mesure de la capacité de l'électrode de capteur avec un dispositif de détection, un convertisseur A/N étant couplé à la deuxième branche de courant pour la préparation de la tension.

6. Dispositif de capteur capacitif selon la revendication 5, dans lequel la tension en chute dans la deuxième branche de courant peut être saisie avec le dispositif de détection respectivement après une pluralité de processus de commutation du dispositif de commutation SW1, de sorte que la valeur de tension dépendant de l'état de charge du condensateur de maintien s'accumule au fil de la pluralité des processus de commutation.

7. Dispositif de capteur capacitif selon l'une des revendications précédentes, dans lequel une première résistance auxiliaire (R1) est disposée dans la première branche de courant, et
dans lequel au moins une deuxième résistance auxiliaire (R2) est disposée dans la deuxième branche de courant.

8. Procédé pour saisir une capacité d'une électrode de capteur avec les étapes suivantes :
la charge d'une électrode de capteur par couplage de l'électrode de capteur à une tension de service (U0),
le découplage de l'électrode de capteur de la tension de service, et couplage de l'électrode de capteur à une capacité de compensation (C12) afin de provoquer une compensation de charge entre la capacité de compensation et l'électrode de capteur,
dans lequel la capacité de compensation est formée par un ou plusieurs condensateurs qui peuvent être couplés via un dispositif de commutation, au choix, à une tension de compensation, à la masse ou de manière libre de potentiel à l'encontre de l'électrode de capteur,
dans lequel une déviation de la charge résiduelle de l'électrode de capteur s'effectue grâce à une première branche de courant d'un miroir de courant, dans lequel un courant correspondant est provoqué dans une deuxième branche de courant du miroir de courant et
dans lequel un condensateur de maintien ajouté dans la deuxième branche de courant est rechargé par le courant provoqué,
la répétition multiple des étapes précédentes et
l'évaluation qui s'en suit de l'état de charge du condensateur de maintien en tant que mesure pour la capacité de l'électrode de capteur,
dans lequel la tension de compensation est variable et est prescrite en fonction de l'état de charge déterminé de la capacité de maintien.

9. Procédé selon la revendication 8, dans lequel le couplage des capacités individuelles à l'électrode de capteur est effectué en fonction de l'état de charge déterminé de la capacité de maintien.
